# EUROPÄISCHE PATENTANMELDUNG

(11) **EP 1 126 609 A1**
(43) Veröffentlichungstag der Anmeldung: **22.08.2001**
(21) Anmeldenummer: 01102065.8
(22) Anmeldetag: 30.01.2001
(51) Int. Cl.: H03K 5/13, G01R 31/28

(54) **Anordnung zum Generieren von Signalimpulsen mit definierten Pulslängen in einem Baustein mit BIST-Funktion**

(30) Priorität: 11.02.2000 DE 10006236
(71) Anmelder: Infineon Technologies AG, 81669 München (DE)
(72) Erfinder: Kaiser, Robert, 86916 Kaufering (DE); Krasser, Hans-Jürgen, 81737 München (DE); Schamberger, Florian, 83435 Bad Reichenhall (DE); Schneider, Helmut, 80993 München (DE)
(74) Vertreter: MÜLLER & HOFFMANN Patentanwälte

(57) **Zusammenfassung**

Die vorliegende Erfindung betrifft eine Anordnung zum Generieren von Signalimpulsen mit definierten Pulslängen in einem Baustein mit BIST-Funktion, dem die Signalimpulse von außen mittels eines Testers zugeführt werden, bei der in dem Baustein ein variables Verzögerungsglied (1) vorgesehen ist, das in einer Anlernphase die Pulslängen der von außen zugeführten Signalimpulse nachmißt, und bei der die so nachgemessenen Pulslängen in jeweils einem Register (Reg 1, Reg 2, ..., Reg k) gespeichert werden. Das variable Verzögerungsglied (1) besteht aus einer Reihenschaltung von Invertern (2), zu denen jeweils eine verzögerungsfreie Signalstrecke (5, 10) zum Einschreiben in die Register (Reg 1, Reg 2, ..., Reg k) und Auslesen aus den Registern (Reg 1, Reg 2, ..., Reg k) parallel liegt.

## Beschreibung

Die vorliegende Erfindung betrifft eine Anordnung zum Generieren von Signalimulsen mit definierten Pulslängen in einem Baustein mit BIST-Funktion nach dem Oberbegriff des Patentanspuches 1.

Unter einer BIST-Funktion (BIST = "Built-In-Self-Test") wird die Fähigkeit eines Bausteines verstanden, mittels einer in den Baustein integrierten Logik den Baustein oder einen Teil von diesem, ein sogenanntes DUT (DUT = "Device-Under-Test" bzw. getestete Vorrichtung) einem Selbsttest zu unterwerfen. Ein solcher Selbsttest setzt oft voraus, daß das DUT intern benötigte Signalimpulse mit definierten Pulslängen, auch "separate Zeitwerte" genannt, wie beispielsweise Trcd (rcd = RAS CAS Delay), nämlich der Zeitwert, der angibt, wie kurz nach einem Öffnen einer Wortleitung Information aus einem Zellenfeld ausgelesen werden kann, oder Tas (as = address set-up), also ein Adreßeinstellzeitwert, speichert.

Bisher wurden diese Signalimpulse mit definierten Pulslängen bzw. Zeitwerten dem DUT von einem Tester von außen zugeliefert, was mit verschiedenen Nachteilen verbunden ist: der Tester muß für jeden Test, bei welchem Signalimpulse mit definierten Pulslängen benötigt werden, erneut an das DUT angelegt werden. Gegebenenfalls werden hierfür zahlreiche Testerkanäle benötigt, wenn zum Anlegen der einzelnen Signalimpulse mit definierten Pulslängen verschiedene Pins (Anschlüsse) erforderlich sind. Technologie- und Prozeßschwankungen können beispielsweise bei Einsatz von mehreren Testern zum Testen einer Vielzahl von DUTs zu Fehlmessungen führen.

Aus der DE 4244696 C2 ist eine Zeitfeineinstellschaltung bekannt, die ein Ausgangssignal mit einer genau gesteuerten zeitlichen Flanke aufgrund eines Eingangssignals mit einer groben zeitlichen Flanke bildet. Über einen Datenbus wird ein Eingangsdatensignal, das eine gewünschte programmierte digitale Verzögerung festlegt, in ein Alpharegister geschrieben. Die höchstwertigen Bits des im Alpharegister gespeicherten Werts werden an eine Abgriffsverzögerungsleitung angelegt, um eine grobe Verzögerungszeit vorzugeben. Die niederwertigen Bit des im Alpharegister gespeicherten Werts werden als Adresse an ein RAM geliefert, das Kalibrierungsdaten für eine zugehörige Feinverzögerung über ein Register ebenfalls in die Abgriffsverzögerungsleitung abgibt. Die Abgriffsverzögerungsleitung kombiniert aufgrund der beiden, ihr zugeführten Daten die grobe und die feine Verzögerungszeit, so dass sich die gewünschte Verzögerungszeit ergibt. Mit Hilfe eines Flip-Flops und eines Phasendetektors wird die Verzögerungsleitung so nachgestellt, daß die Signalflanken des Ausgangssignals mit der fein eingestellten Flanke und die Flanke eines Taktsignals zueinander ausgerichtet sind. Das Ergebnis dieses Kalibrierungsprozesses wird in dem RAM und dem Register abgespeichert. Durch die Kalibrierung kann so ein Selbsttest der Schaltung während des Herstellungstestvorgangs durchgeführt werden.

Weiterhin ist aus der US 5621739 A eine Pufferschaltung mit einer Verzögerungskette mit einstelbarer Verzögerung bekannt. Diese Verzögerungskette besteht aus einer Reihenschaltung von Invertern.

Es ist daher Aufgabe der vorliegenden Erfindung, eine Anordnung der eingangs genannten Art so zu verbessern, daß diese auf dem Baustein selbst die Signalimpulse mit definierten Pulslängen zu generieren vermag und dabei einfach aufgebaut ist.

Diese Aufgabe wird bei einer Anordnung nach dem Oberbegriff des Patentanspruches 1 erfindungsgemäß durch die in dessen kennzeichnendem Teil enthaltenen Merkmale gelöst. Vorteilhafte Weiterbildungen der Erfindung ergeben sich aus den Unteransprüchen.

Die vorliegende Anordnung ermöglicht die Lieferung von Signalimpulsen mit definierten Pulslängen bzw. von separaten Zeitwerten auf überraschend einfache Weise: der externe Tester führt zunächst zu Beginn eines Testens die benötigten Signalimpulse mit definierten Pulslängen dem Baustein (bzw. dem DUT) zu. Der Baustein mißt aus diesen Signalimpulsen ein erstes Zeitintervall in seinem eigenen variablen Verzögerungsglied nach und speichert das Ergebnis in einem entsprechenden Register. Dies geschieht nun für alle benötigten definierten Pulslängen, also beispielsweise für Trcd, Tas usw. Insgesamt werden dabei so viele Register wie definierte Pulslängen benötigt.

Der Baustein kann nun die benötigten wie definierte Pulslängen für Justagezwecke und zum Ausmessen von Signallaufzeiten bei Bedarf selbst erzeugen, ohne den Tester weiterhin dafür zu benötigen. Es ist aber auch möglich, daß der Baustein Signallaufzeiten selbständig ausmißt und anschließend an den Tester in analoger oder digitaler Form übermittelt.

Die vorliegende Anordnung ermöglicht eine Reihe von Vorteilen, die mit bestehenden Anordnungen, bei denen Signalimpulse mit definierten Impulslängen allein von externen Testern geliefert werden, nicht zu erzielen sind:

Der externe Tester muß jeden Signalimpuls mit definierter Impulslänge nur einmal anlegen. Zum Justieren der Anordnung können Testerkanäle eingespart werden, da hierfür maximal zwei Pins notwendig sind, über die alle definierten Impulslängen bzw. separaten Zeitwerte von dem externen Tester anzulegen sind. Auf dem Baustein können die einmal abgespeicherten Impulslängen bzw. Zeiten bis zu einem nächsten Testlauf abgespeichert und dann ohne weiteres reproduziert werden. Fehlmessungen infolge von Technologie- oder Prozeßschwankungen, die bei der Herstellung verschiedener Tester und Bausteine auftreten, liegen praktisch nicht vor. Als Referenzmaß und für die Messung wird lediglich ein variables Verzögerungsglied auf dem Baustein selbst benötigt, das im übrigen für alle Messungen der verschiedenen definierten Impulslängen bzw. separaten Zeitwerte eingesetzt wird. Mittels der Register kann der Baustein ohne weiteres die verschiedenen definierten Impulslängen bzw. separaten Zeitwerte abspeichern und bei Bedarf gegebenenfalls sogar an den externen Tester ausgeben.

Wesentlich an der vorliegenden Anordnung ist also zunächst die Verwendung nur eines variablen Verzögerungsgliedes, das die von dem externen Tester in den Baustein eingeprägten Pulslängen bzw. Zeiten nachmißt oder intern erzeugte Pulslängen bzw. Zeiten ausmißt und die Ergebnisse in den jeweiligen Registern abspeichert. Mit diesem variablen Verzögerungsglied und dem entsprechenden Registerwert kann umgekehrt wieder das gewünschte Zeitintervall auf dem Baustein selbst reproduziert werden. Das variable Verzögerungsglied wird erfindungsgemäß unter Ausnutzung von Inverterlaufzeiten realisiert. Die Dimensionierung beispielsweise der einzelnen Inverter ist von der kleinsten angestrebten Auflösung abhängig: Je mehr Inverter mit kurzen Laufzeiten eingesetzt werden, desto höher wird die zeitliche Auflösung. Gegebenenfalls kann auch ein variables Verzögerungsglied vorteilhaft sein, das in "gemischter" Weise aufgebaut ist, wenn große Zeitintervalle sehr genau gemessen werden soll. Hier ist es zweckmäßig, nach längeren Laufzeiten für die großen Zeitintervalle kurze Laufzeiten im Bereich von Anfang und Ende der großen Zeitintervalle vorzusehen, damit diese genau gemessen werden können.

Bei der erfindungsgemäßen Anordnung kann der Baustein von dem externen Tester eines oder mehrere Zeitintervalle "lernen" und diese anschließend intern wiederholen oder mit eigenen intern gemessenen Zeitintervallen vergleichen, wenn beispielsweise beurteilt werden soll, ob der betreffende Baustein einen zeitlichen Spezifikationswert überschreitet oder unterschreitet. Schließlich kann der Baustein auch eine oder mehrere interne Zeitintervalle messen, speichern und diese anschließend in digitaler oder analoger Form an den externen Tester übermitteln.

Die erfindungsgemäße Anordnung kann in vorteilhafter Weise auch für einen normalen Betrieb von Bausteinen bzw. Chips eingesetzt werden. Damit ist es dann möglich, einem Chip sein gewünschtes Zeitverhalten von außen vorzugeben, was gegegebenenfalls auch während eines Betriebs des Chips geschehen kann.

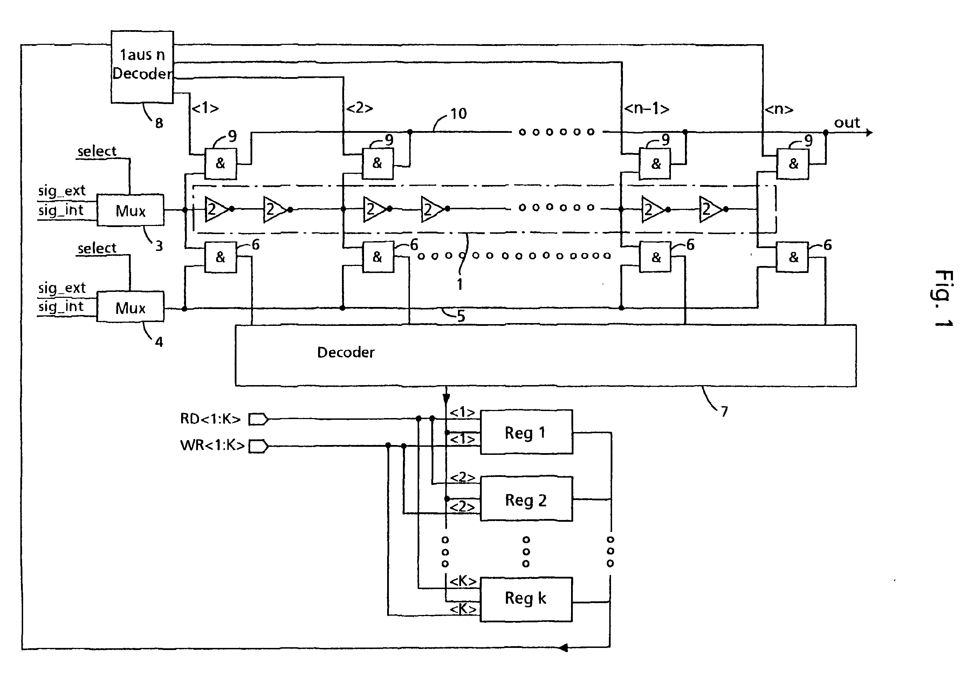

Nachfolgend wird die Erfindung anhand der Zeichnung näher erläutert, in deren einziger Figur ein Ausführungsbeispiel der erfindungsgemäßen Anordnung mit einem variablen Verzögerungsglied gezeigt ist.

Die erfindungsgemäße Anordnung umfaßt ein variables Verzögerungsglied 1, das aus einer Vielzahl von Invertern 2 besteht, die in Reihe hintereinander geschaltet sind, wobei in dieser Reihenschaltung nach jeweils einer geradzahligen Anzahl von Invertern 2 ein Abgriff vorliegt, durch das das bis zu diesem Abgriff durch die Inverter 2 verzögerte Signal jeweils nach außen geführt wird.

Ein externer Tester legt zum "Anlernen" der Anordnung ein externes Signal sig_ext an Multiplexer 3, 4, die über ein Ansteuersignal select zu einem internen Signal sig_int umschaltbar sind, auf das weiter unten näher eingegangen wird. Das externe Signal sig_ext besteht beispielsweise aus einem Impuls mit einer Anstiegsflanke der in einem definierten Abstand eine Abfallflanke folgt, um so eine Impulslänge als Zeitwert bzw. ein Zeitintervall zu definieren. Dieses Signal sig_ext gelangt über den Multiplexer 3 an den Eingang des variablen Verzögerungsgliedes 1 und gleichzeitig über den Multiplexer 4 an eine parallel zum variablen Verzögerungsglied 1 verlaufende verzögerungsfreie Signalstrecke 5. Dadurch liegen an zwischen dem Eingang des variablen Verzögerungsgliedes 1 bzw. Abgriffen von diesem und der verzögerungsfreien Signalstrecke 5 geschalteten UND-Gattern 6 einerseits das über das variable Verzögerungsglied 1 verzögerte externe Signal und das über die Signalstrecke 5 verzögerungsfreie externe Signal sig_ext an. Das heißt, in dem variablen Verzögerungsglied 1 läuft das externe Signal sig_ext verzögert durch, während es in der verzögerungsfreien Signalstrecke 5 keine Verzögerung erfährt. Die Impulslänge bzw. das Intervall des externen Signales sig_ext wird nun dadurch gemessen, daß der Abgriff bestimmt wird, bei welchem das entsprechende UND-Gatter 6 die gleichen Eingangssignale, also beispielsweise "0" empfängt, wenn auch an dieser Stelle das externe Signal wieder auf 0 abgefallen ist. Das heißt, sobald an einem Abgriff im variablen Verzögerungsglied 1 das externe Signal sig_ext auf 0 geht, liefert das entsprechende UND-Gatter 6 ein Ausgangssignal zu einem Decoder 7 welcher dann ein diesem gemessenen Zeitwert entsprechendes Datum in einem zugehörigen Register Reg 1, Reg 2, ..., Reg k ablegt.

Über den Eingang sig_int kann ein intern auf dem Baustein erzeugtes Signal in den Multiplexer 3 bzw. 4 eingespeist und mit den bereits in den Registern Reg 1, Reg 2, .., Reg k gespeicherten Zeitwerten vergleichen werden. Dies ist insbesondere dann möglich, wenn zuvor durch Anlegen entsprechender externer Signale sig_ext ausreichend viele definierte Pulslängen bzw. Zeitwerte in den Registern Reg 1, Reg 2, ..., Reg k abgelegt wurden, so daß ein ausreichend genauer Vergleich möglich ist. Das Auslesen der Register Reg 1, Reg 2, ..., Reg k, die über Lese- und Schreib-Befehlssignale RD bzw. WR ansteuerbar sind, erfolgt in "umgekehrter" Weise zum Einschreiben: nach Anlegen des Lese-Befehlssignales RD werden die Register Reg 1, Reg 2, ..., Reg k über einen (1 aus n)-Decoder 8 ausgelesen, der die Inhalte der Register zugeordneten UND-Gattern 9 einer weiteren verzögerungsfreien Signalstrecke 10 zuführt. Dadurch wird das der im zugehörigen Register Reg 1, Reg 2, ..., Reg k abgelegten Zeitdauer entsprechende UND-Gatter 9 geöffnet, so daß an einem Ausgang OUT über das variable Verzögerungsglied 1 ein Signal mit der abgespeicherten Zeitdauer erhalten wird.

## Patentansprüche

1. Anordnung zum Generieren von Signalimpulsen mit definierten Pulslängen in einem Baustein mit BIST-Funktion, dem die Signalimpulse von außen mittels eines Testers zugeführt werden, bei der in dem Baustein ein variables Verzögerungsglied (1) vorgesehen ist, das in einer Anlernphase die Pulslängen der von außen zugeführten Signalimpulse nachmißt, und bei der die so nachgemessenen Pulslängen in jeweils einem Register (Reg 1, Reg 2, ..., Reg k) gespeichert werden,
**dadurch gekennzeichnet,**
daß das variable Verzögerungsglied (1) aus einer Reihenschaltung von Invertern (2) besteht, zu denen jeweils eine verzögerungsfreie Signalstrecke (5, 10) zum Einschreiben in die Register (Reg 1, Reg 2, ..., Reg k) und Auslesen aus den Registern (Reg 1, Reg 2, ..., Reg k) parallel liegt.

2. Anordnung nach Anspruch 1,
**dadurch gekennzeichnet,**
daß zwischen der verzögerungsfreien Einschreib-Signalstrecke (5) und dem variablen Verzögerungsglied (1) nach jeweils einer geradzahligen Anzahl von Invertern (2) UND-Gatter (6) liegen, deren Ausgang über einen Decoder (7) an die Register (Reg 1, Reg 2, ..., Reg k) angeschlossen ist.

3. Anordnung nach Anspruch 1 oder 2,
**dadurch gekennzeichnet,**
daß zwischen der verzögerungsfreien Auslese-Signalstrecke (10) und dem variablen Verzögerungsglied (1) nach jeweils einer geradzahligen Anzahl von Invertern (2) UND-Gatter (9) liegen, deren einer Eingang über einen (1 aus n)-Decoder (8) mit den Registern (n: Anzahl der UND-Gatter) und deren anderer Eingang mit dem variablen Verzögerungsglied (1) verbunden ist und deren Ausgang an die verzögerungsfreie Auslese-Signalstrecke (10) angeschlossen ist.
